# EUROPÄISCHE PATENTSCHRIFT

(11) **EP 1 368 840 B1**
(45) Veröffentlichungstag und Bekanntmachung des Hinweises auf die Patenterteilung: **15.02.2006**
(21) Anmeldenummer: 02700093.4
(22) Anmeldetag: 04.03.2002
(51) Int. Cl.: H01L 39/12, H01L 39/24

(54) **VERFAHREN ZUR HERSTELLUNG EINES SUPRALEITENDEN MATERIALS AUS MgB2**
METHOD FOR PRODUCING A SUPERCONDUCTING MATERIAL MADE OF MgB2
PROCEDE DE PRODUCTION D'UN MATERIAU SUPRACONDUCTEUR EN MgB2

(30) Priorität: 05.03.2001 CH 411012001
(43) Veröffentlichungstag der Anmeldung: 10.12.2003
(73) Patentinhaber: Eidgenössische Technische Hochschule Zürich, 8092 Zürich (CH)
(72) Erfinder: REINOSO, Juan, Matias, CH-8406 Winterthur (CH); OTTINGER, Frank, CH-8057 Zürich (CH); WOERLE, Michael, CH-8005 Zürich (CH); NESPER, Reinhard, CH-8802 Kilchberg (CH)
(74) Vertreter: Groner, Manfred
(86) Internationale Anmeldenummer: PCT/CH2002/000131
(87) Internationale Veröffentlichungsnummer: WO 2002/071499

(56) Entgegenhaltungen:
- FR-A- 2 563 535
- US-A- 5 156 806
- DATABASE CAPLUS [Online] CHEMICAL ABSTRACTS SERVICE, COLUMBUS, OHIO, US; 17. Februar 2001 (2001-02-17) CANFIELD, P.C. ET AL.: "Superconductivity in dense MgB2 wires" retrieved from STN Database accession no. 2001:125001 XP002197802 & "ARXIV:COND_MAT/0102289" LOS ALAMOS NATIONAL LABORATORY; PREPRINT ARCHIVE; CONDENSED MATTER,
- DATABASE CAPLUS [Online] CHEMICAL ABSTRACTS SERVICE, COLUMBUS, OHIO, US; 23. Februar 2001 (2001-02-23) SUMPTION, M.D. ET AL.: "Transport current in MgB2 based superconducting strand at 4.2 K and self-field" Database accession no. 2001:159743 XP002197803 & "ARXIV:COND_MAT/0102441" LOS ALAMOS NATIONAL LABORATORY, PREPRINT ARCHIVE, CONDENSED MATTER,

## Beschreibung

Die Erfindung betrifft ein Verfahren zur Herstellung des supraleitenden Materials MgB₂ in verschiedenen geometrischen Formen. Die Erfindung betrifft zudem ein nach diesem Verfahren hergestelltes Material sowie eine Vorlegierung zur Durchführung des Verfahrens.

MgB₂ ist seit langem bekannt. Es kristallisiert in der hexagonalen AlB₂ Struktur und besteht aus alternierenden Schichten aus Mg Atomen und graphitähnlichen Schichten aus B. Die supraleitenden Eigenschaften wurden erst im Januar 2001 entdeckt und diese waren aufgrund der hohen Sprungtemperatur von 39 K aufsehenerregend. Es wird hier auf die Veröffentlichungen von S.L. Bud'ko, G. Lapertot, G. Petrovic, C.E. Cunningham, N. Anderson and P.C. Canfield, Ames Laboratory and Department of Physics and Astronomy Iowa State University, Ames, IA 50011 (January 30, 2001) und J. Kortus, I.I. Mazin, K.D. Belashchenko, V.P. Antropov, L.L. Boyer, Center for Computational Materials Science, Code 6390, Naval Research Laboratory, Washington, DC 20375, Ames Laboratory, ISU, Ames, IA, 50011 (January 30, 2001) verwiesen.

MgB₂ ist sehr spröde und die Herstellung technischer Teile und insbesondere Drähten aus diesem Material ist aufwendig.

Der Erfindung gemäß den Ansprüchen 1 bis 23 liegt die Aufgabe zugrunde, ein Verfahren zu schaffen, das die Herstellung von Formteilen aus supraleitendem MgB₂ ermöglicht. Die Aufgabe ist dadurch gelöst, dass eine Mg und B sowie wenigstens eine weitere Komponente enthaltende, verformbare Vorlegierung hergestellt und aus der verformten Vorlegierung diese wenigstens eine weitere Komponente entfernt wird. Beim erfindungsgemässen Verfahren wird somit nicht das supraleitende Material, sondern eine verformbare Vorlegierung zur Herstellung der gewünschten Form bearbeitet. Eine besonders geeignete Vorlegierung ist eine LiMgB-Legierung. Diese lässt sich als sehr stabile Phase herstellen und ist beispielsweise schmiedbar, giessbar und pressbar. Nach dem Verformen dieser Vorlegierung wird diese durch Entfernen des Li in das supraleitende Material übergeführt. Das Entfernen des Li kann ohne Verändern der Form erfolgen. Nach dem Verformen der Vorlegierung wird die Form beim Übergang zum supraleitenden Material somit beibehalten. LiMgB ist als Elektrodenmaterial aus der FR-A-2 563 535 an sich bekannt.

Die Vorlegierung kann in einer Schmelze bei einer Temperatur von 180° - 600° C hergestellt werden. Es hat sich gezeigt, dass eine Schmelztemperatur zwischen 180° und 450° C besonders vorteilhaft ist. Die Vorlegierung kann jedoch auch durch Mahlen der Komponenten und insbesondere durch Kaltmahlen hergestellt werden. Bei einer Temperatur von etwa 450° C ist die Phase sehr homogen und geht bei einer weiteren Temperaturerhöhung in einen pastösen Zustand über. In diesem Zustand kann die Vorlegierung geformt werden. Alternativ kann die homogene Phase der Vorlegierung abgekühlt und anschliessend aufgrund ihrer Duktilität verformt, beispielsweise geschmiedet oder gepresst werden.

Die weitere Komponente und insbesondere Li kann durch Tempern entfernt werden. Vorzugsweise erfolgt dies im Vakuum. Ein Entfernen der weiteren Komponente ist aber auch durch andere chemische oder physikalische Verfahren, beispielsweise mittels Elektrolyse oder Solvolyse möglich.

Eine besonders geeignete Zusammensetzung der Vorlegierung besteht aus 10% - 97% (Atomprozent) Li, 1% - 30% (Atomprozent) Mg und 2% - 60% (Atomprozent) B.

Die Vorlegierung eignet sich besonders zum Dotieren, beispielsweise mit Be und/oder Al.

Das nach dem Verfahren hergestellte Material ist insbesondere ein Formteil. Insbesondere ist dieser Formteil ein Draht, insbesondere ein geschmiedeter, gepresster oder gezogener Draht.

Beim erfindungsgemässen Verfahren wird aus Mg und B sowie einer weiteren Komponente, insbesondere Li durch Aufschmelzen eine homogene Phase hergestellt. Das Schmelzen erfolgt in einem Temperaturbereich von 180° - 600° C, vorzugsweise bei 180° - 450° C. Es sind jedoch auch andere Temperaturbereiche denkbar. Eine Herstellung ist auch durch Mahlen der genannten Komponenten und insbesondere durch Kaltmahlen hergestellt. In dieser Schmelze wird bei höheren Temperaturen beispielsweise bei etwa 450° C eine sehr hohe Homogenität erreicht. Wird diese Temperatur überschritten, so wird die LiMgB-Legierung zunehmend härter. Dieses an sich ungewöhnliche Verhalten kann zur Herstellung einer vorformbaren Vorlegierung benutzt werden. Die Vorlegierung wird bei dieser erhöhten Temperatur, bei der sie hart, beispielsweise pastös und duktil ist, verformt, beispielsweise geschmiedet. Durch Tempern im Vakuum wird diese geformte Vorlegierung in das supraleitende Material übergeführt. Bei dieser Behandlung wird das Li bzw. die weitere Komponente entfernt. Alternativ zum Tempern ist eine Entfernung der weiteren Komponente auch elektrolytisch durch Deinterkalation möglich. Ferner kann die weitere Komponente chemisch entfernt werden. Hierzu eignet sich insbesondere eine Solvolyse, beispielsweise in Alkohol, insbesondere Isopropanol bzw. Isopropanol/Ethanol-Mischungen.

Die Vorlegierung kann dotiert werden. Insbesondere kann Mg überdotiert werden. Ein Dotieren ist insbesondere mit Be und/oder Al vorteilhaft.

Zum Verformen der Vorlegierung sind aufgrund der Duktilität dieser Vorlegierung sehr viele Arbeitsverfahren möglich. Insbesondere kann die Vorlegierung geschmiedet, gegossen, gepresst oder extrudiert werden. Dies kann bei erhöhter Temperatur, insbesondere einer Temperatur über 450° C oder auch im abgekühlten Zustand bei Raumtemperatur erfolgen. Es sind im wesentlichen alle Formen herstellbar. Technisch interessant ist aber insbesondere die Herstellung von Drähten, die in einem gewünschten Durchmesser und Längen sehr einfach hergestellt werden können.

## Patentansprüche

1. Verfahren zur Herstellung des supraleitenden Materials MgB₂, **dadurch gekennzeichnet, dass** eine Mg und B sowie wenigstens eine weitere Komponente enthaltende, verformbare Vorlegierung hergestellt und aus dieser Vorlegierung diese weitere Komponente wenigstens teilweise entfernt wird.

2. Verfahren nach Anspruch 1, **dadurch gekennzeichnet, dass** die Vorlegierung eine LiMgB-Legierung ist.

3. Verfahren nach Anspruch 2, **dadurch gekennzeichnet, dass** die LiMgB-Legierung in einer Schmelze bei 180° - 600° C, vorzugsweise bei 180° - 450° C hergestellt wird.

4. Verfahren nach Anspruch 1 oder 2, **dadurch gekennzeichnet, dass** die LiMgB-Legierung durch Mahlen der Komponenten und insbesondere durch Kaltmahlen hergestellt wird.

5. Verfahren nach einem der Ansprüche 1 bis 4, **dadurch gekennzeichnet, dass** die Vorlegierung oberhalb von etwa 450° C zunehmend härter und insbesondere pastös wird.

6. Verfahren nach einem der Ansprüche 1 bis 5, **dadurch gekennzeichnet, dass** die genannte weitere Komponente durch Tempern entfernt wird.

7. Verfahren nach Anspruch 6, **dadurch gekennzeichnet, dass** die genannte weitere Komponente im Vakuum entfernt wird.

8. Verfahren nach einem der Ansprüche 1 bis 5, **dadurch gekennzeichnet, dass** die genannte weitere Komponente elektrolytisch durch Deinterkalation entfernt wird.

9. Verfahren nach einem der Ansprüche 1 bis 5, **dadurch gekennzeichnet, dass** die genannte weitere Komponente durch Solvolyse herausgelöst wird.

10. Verfahren nach einem der Ansprüche 1 bis 9, **dadurch gekennzeichnet, dass** die genannte Komponente Li ist.

11. Verfahren nach einem der Ansprüche 1 bis 10, **dadurch gekennzeichnet, dass** die Vorlegierung eine folgende Zusammensetzung aufweist:
| | |
|---|---|
| Li | 10 - 97 % (Atomprozent) |
| Mg | 1 - 30 % (Atomprozent) |
| B | 2 - 60 % (Atomprozent) |

12. Verfahren nach einem der Ansprüche 1 bis 11, **dadurch gekennzeichnet, dass** die Vorlegierung dotiert wird.

13. Verfahren nach Anspruch 12, **dadurch gekennzeichnet, dass** die Vorlegierung mit Be und/oder A1 dotiert wird.

14. Verfahren nach einem der Ansprüche 1 bis 13, **dadurch gekennzeichnet, dass** Mg überdotiert wird.

15. Verfahren nach einem der Ansprüche 1 bis 14, **dadurch gekennzeichnet, dass** die Vorlegierung verformt wird.

16. Verfahren nach Anspruch 15, **dadurch gekennzeichnet, dass** die vorlegierung vergossen, verpresst oder geschmiedet wird.

17. Verfahren nach Anspruch 15 oder 16, **dadurch gekennzeichnet, dass** die Vorlegierung zu einem Draht geformt wird.

18. Nach dem Verfahren gemäss Anspruch 1 hergestelltes supraleitendes Material, **dadurch gekennzeichnet, dass** es ein Formteil ist und dass die genannte weitere Komponente teilweise entfernt ist.

19. Material nach Anspruch 18, **dadurch gekennzeichnet, dass** die genannte weitere Komponente Li ist.

20. Verwendung einer Vorlegierung zur Herstellung eines supraleitenden Materials nach Anspruch 18 oder 19, **dadurch gekennzeichnet, dass** die Vorlegierung eine LiMgB-Legierung ist und dass sie geschmiedet, gegossen, gepresst oder extrudiert ist und dass sie zur Herstellung eines supraleitenden Materials mit wenigstens teilweise entferntem Li vorgesehen ist.

21. Verwendung einer Vorlegierung nach Anspruch 20, **dadurch gekennzeichnet, dass** die Vorlegierung dotiert ist.

22. Verwendung einer Vorlegierung nach Anspruch 20 oder 21, **dadurch gekennzeichnet, dass** Mg überdotiert ist.

23. Verwendung einer Vorlegierung nach Anspruch 20, **dadurch gekennzeichnet, dass** die Vorlegierung zu einem Draht geformt ist.

## Revendications

1. Procédé de fabrication du matériau supraconducteur MgB₂, **caractérisé en ce que** l'on prépare un préalliage façonnable qui contient Mg et B et au moins un autre composant, au moins une partie de cet autre composant étant ensuite enlevée de ce préalliage.

2. Procédé selon la revendication 1, **caractérisé en ce que** le préalliage est un alliage de LiMgB.

3. Procédé selon la revendication 2, **caractérisé en ce que** l'alliage de LiMgB est préparé par fusion entre 180° et 600°C et de préférence entre 180° et 450°C.

4. Procédé selon les revendications 1 ou 2,
**caractérisé en ce que** l'alliage de LiMgB est préparé par broyage des composants et en particulier par broyage à froid.

5. Procédé selon l'une des revendications 1 à 4, **caractérisé en ce que** le préalliage devient de plus en plus dur et en particulier devient pâteux au-dessus d'environ 450°C.

6. Procédé selon l'une des revendications 1 à 5, **caractérisé en ce que** ledit autre composant est enlevé par recuit.

7. Procédé selon la revendication 6, **caractérisé en ce que** ledit autre composant est enlevé sous vide.

8. Procédé selon l'une des revendications 1 à 5, **caractérisé en ce que** ledit autre composant est enlevé électrolytiquement par désintercalation.

9. Procédé selon l'une des revendications 1 à 5, **caractérisé en ce que** ledit autre composant est enlevé par solvolyse.

10. Procédé selon l'une des revendications 1 à 9, **caractérisé en ce que** ledit composant est Li.

11. Procédé selon l'une des revendications 1 à 10, **caractérisé en ce que** le préalliage présente la composition suivante :
| | |
|---|---|
| Li | 10 à 97 % (atomiques) |
| Mg | 1 à 30 % (atomiques) |
| B | 2 à 60 % (atomiques) |

12. Procédé selon l'une des revendications 1 à 11, **caractérisé en ce que** le préalliage est dopé.

13. Procédé selon la revendication 12, **caractérisé en ce que** le préalliage est dopé au Be et/ou à l'Al.

14. Procédé selon l'une des revendications 1 à 13, **caractérisé en ce que** le Mg est surdopé.

15. Procédé selon l'une des revendications 1 à 14, **caractérisé en ce que** le préalliage est façonné.

16. Procédé selon la revendication 15, **caractérisé en ce que** le préalliage est coulé, comprimé ou forgé.

17. Procédé selon les revendications 15 ou 16, **caractérisé en ce que** le préalliage est façonné en fil.

18. Matériau supraconducteur fabriqué selon la revendication 1, **caractérisé en ce qu'**il est une pièce façonnée et **en ce qu'**au moins une partie dudit autre composant est enlevée.

19. Matériau selon la revendication 18, **caractérisé en ce que** ledit autre composant est Li.

20. Utilisation d'un préalliage pour la fabrication d'un matériau supraconducteur selon les revendications 18 ou 19, **caractérisé en ce que** le préalliage est un alliage de LiMgB, **en ce qu'**il est forgé, coulé, comprimé ou extrudé et **en ce qu'**il est prévu pour fabriquer un matériau supraconducteur dont au moins une partie du Li a été enlevée.

21. Utilisation d'un préalliage selon la revendication 20, **caractérisée en ce que** le préalliage est dopé.

22. Utilisation d'un préalliage selon les revendications 20 ou 21, **caractérisée en ce que** le Mg est surdopé.

23. Utilisation d'un préalliage selon la revendication 20, **caractérisée en ce que** le préalliage est façonné en fil.

## Claims

1. A process for producing the superconducting material MgB₂, **characterized in that** a shapeable master alloy containing Mg and B, as well as at least one additional constituent is produced, and this at least one additional constituent is at least partially removed from it.

2. A process according to claim 1, **characterized in that** the master alloy is a LiMgB alloy.

3. A process according to claim 2, **characterized in that** the LiMgB alloy is produced in a molten mass at 180°-600°C, preferably at 180°-450°C.

4. A process according to claim 1 or 2, **characterized in that** the LiMgB alloy is produced by grinding the constituents, specifically by cold grinding.

5. A process according to any of claims 1 through 4, **characterized in that** the master alloy becomes increasingly harder above approximately 450°C, specifically pasty.

6. A process according to any of claims 1 through 5, **characterized in that** the at least one additional constituent is removed by heat-treatment.

7. A process according to claim 6, **characterized in that** the at least additional constituent is removed in the vacuum.

8. A process according to any of claims 1 through 5, **characterized in that** the at least one additional constituent is removed electronically by deintercalation.

9. A process according to any of claims 1 through 5, **characterized in that** the at least one additional constituent is dissolved out by solvolysis.

10. A process according to any of claims 1 through 9, **characterized in that** the at least one additional constituent is Li.

11. A process according to any of claims 1 through 10, **characterized in that** the master alloy has a composition as follows:
| | |
|---|---|
| Li | 10-97% (atom percent) |
| Mg | 1-30% (atom percent) |
| B | 2-60% (atom percent) |

12. A process according to any of claims 1 through 11, **characterized in that** the master alloy is doped.

13. A process according to claim 12, **characterized in that** the master alloy is doped with Be and/or Al.

14. A process according to any of claims 1 through 13, **characterized in that** Mg is over-doped.

15. A process according to any of claims 1 through 14, **characterized in that** the master alloy is shaped.

16. A process according to claim 15, **characterized in that** the master alloy is cast, pressed or forged.

17. A process according to claim 15 or 16, **characterized in that** the master alloy is shaped into a wire.

18. A superconducting material produced according to the process of claim 1, **characterized in that** it is a shaped element and that said additional constituent is at least partially removed.

19. A material according to claim 18, **characterized in that** said additional constituent is Li.

20. Use of a master alloy for the production of a superconducting material according to claim 18 or 19, **characterized in that** the master alloy is a LiMgB alloy and that it is forged, cast, pressed or extruded and that it is intended for the production of a superconducting material with at least partially removed Li.

21. Use of a master alloy according to claim 20, **characterized in that** the master alloy is doped.

22. Use of a master alloy according to claim 20 or 21, **characterized in that** Mg is over-doped.

23. Use of a master alloy according to claim 20, **characterized in that** the master alloy is shaped into a wire.
